# EUROPEAN PATENT SPECIFICATION

(11) **EP 3 441 483 B1**
(45) Date of publication and mention of the grant of the patent: **05.08.2020**
(21) Application number: 17193771.7
(22) Date of filing: 28.09.2017
(51) Int. Cl.: C22B 9/04, C30B 25/00, C30B 29/02

(54) **PRODUCTION SYSTEM FOR A HAFNIUM CRYSTAL BAR AND METHOD FOR PRODUCTION THEREOF**
HERSTELLUNGSSYSTEM FÜR EINE HAFNIUMKRISTALLSTANGE UND VERFAHREN ZUR HERSTELLUNG DAFÜR
SYSTÈME DE PRODUCTION D'UNE BARRE CRISTALLINE D'HAFNIUM ET PROCÉDÉ DE PRODUCTION ASSOCIÉ

(30) Priority: 07.08.2017 CN 201710665149
(43) Date of publication of application: 13.02.2019
(73) Proprietor: Nanjing Youtian Metal Technology Co., Ltd., Nanjing (CN)
(72) Inventor: CHEN, Huaihao, Nanjing (CN)
(74) Representative: Berkkam, Ayfer

(56) References cited:
- CN-A- 102 296 191
- JP-A- S61 242 993
- US-A- 4 239 531
- N/a: "High Strength Copper-Based Conductor Materials" In: "Copper Alloys: Preparation, Properties and Applications", 1 October 2011 (2011-10-01), Nova Science Publishers, XP055636624, ISBN: 978-1-62081-544-1 pages 167-168,

## Description

### Cross Reference to Related Applications

This application claims priority to Chinese Patent Application No. CN201710665149.5, filed on August 07, 2017.

### Technical Field

The present invention relates a production system for a hafnium crystal bar and the method thereof.

### Background of the Invention

At present, the industrial production technology of the hafnium crystal bar is monopolized and blocked by the foreign companies. The domestic production technology is immature and unstable, and stays in the laboratory stage and faces the following problems: (1) The production efficiency and the production of single furnace is low, and the production cost is high, which cannot meet the requirements of industrial production. (2) The problem of a low production rate in a later production stage cannot be solved. (3) The wire breakage phenomenon cannot be avoided. (4) The crucible pollution is high and the trace element contents cannot meet the standard. (5) The core wire often distorts in the heat and touches the molybdenum insulator, which leads to frequent short-circuit phenomena. (6) The discharging phenomenon caused by a high-voltage in the earlier production stage often breaks the crucible, causes accidents, and also fuses the core wire easily. (7) The ineffective deposition of the iodine makes the effective time of production short. The existence of the problems listed above restricts the production of the hafnium crystal bar seriously. Therefore, the national defense industry and advanced manufacturing industry cannot be supported materially.

Following documents are provided as prior art references:
D1: CN 102 296 191 A (Nanjing Youtian Metal Technology Co Ltd), 28 December 2011.
D4: "High Strength Copper-Based Conductor Materials" In: "Copper Alloys" Preparation, Properties and Applications", 1 October 2011, Nova Science Publishers, XP 055636624, ISBN: 978-1-62081-544-1, pages 167-168.

### Summary of the Invention

The present invention overcomes the shortcomings of the prior art. The technical problem to be solved is to provide a production system for industrially producing a hafnium crystal bar and the method thereof.

In order to solve the technical problem mentioned above, the technical solutions adopted in the present invention are as follows: A production system for a hafnium crystal bar, comprising, a power supply unit with a large DC current, an iodizer, a molybdenum insulator provided inside the iodizer, a thermostatic device capable of accommodating the iodizer, a cooling unit for cooling the iodizer, a vacuum unit for vacuumizing the iodizer, an iodine box for adding iodine into the iodizer, wherein the iodine box is controlled by a ball valve, an electrode unit electrically connected to the power supply unit, wherein the electrode unit is disposed above the iodizer, a crystallization unit provided inside the iodizer, wherein the crystallization unit is connected to the electrode unit, and rough hafnium provided between the iodizer and the molybdenum insulator. The thermostatic device is a structure with an insulation layer provided outside an inner tank, and an electric heating wire is provided between the inner tank and the insulation layer, wherein the inner tank of the thermostatic device is filled with a saline solution. The iodizer is fixedly mounted inside the inner tank of the thermostatic device and is completely immersed in the saline solution. The thermostatic device is further provided with a thermocouple extending into the saline solution, wherein the thermocouple is used for measuring a temperature of the saline solution.

The electrode unit comprises an electrode rod made of a chromium-zirconium-copper rod, a molybdenum electrode rod located below the electrode rod, an electrode tip located at a bottom of the molybdenum electrode rod, wherein the molybdenum electrode rod is connected to the electrode rod by a screw thread, wherein a core wire of the crystallization unit is a hafnium wire and both ends of the core wire are connected to the electrode tip.

A bottom of the molybdenum electrode rod is fixedly connected to a cover of the iodizer through a molybdenum sleeve, and an insulating ferrule is arranged between the molybdenum electrode rod and the molybdenum sleeve.

A lower portion of the molybdenum electrode rod is fixedly provided with an anti-discharge ceramic piece having an inverted L-shaped cross section.

A core wire fixing device is provided inside the iodizer, wherein the core wire fixing device comprises a molybdenum rod connected to the cover of the iodizer, a molybdenum plate connected to the molybdenum rod, and an insulating ceramic piece connected to the molybdenum plate, wherein a molybdenum wire for fixing the core wire is fastened to the insulating ceramic piece.

The cooling unit comprises a thermally conductive fuel tank, a cooling coil peripherally provided around an outer wall of the iodizer, a condenser, and a circulating and stirring system in the thermostatic device, wherein the circulating and stirring system comprising a circulating pipe provided on a side of the inner tank of the thermostatic device, wherein an agitating shaft is provided in the circulating pipe, wherein an agitating vane is provided at a lower part of the agitating shaft, and an upper part of the agitating shaft extends outside of the circulating pipe and connects to a output shaft of a motor.

A cover of the iodizer is fixedly connected to a flange of a body of the iodizer, wherein a sealing ring and a secondary sealing device are arranged between the cover of the iodizer and the flange.

The vacuum unit is connected to the iodizer through a vacuum valve, wherein the vacuum unit includes a triplex pump, wherein a primary pump is a mechanical pump, a secondary pump is a lobe pump and a tertiary pump is a diffusion pump.

A method for producing a hafnium crystal bar using the production system of appended claim 1, comprising the following steps:
a. drying rough hafnium;
b. adding the rough hafnium into a gap between an inner wall of an iodizer and a molybdenum insulator;
c. hanging a core wire onto an electrode tip and fixing the core wire into a core wire fixing device;
d. hermetically connecting a cover of the iodizer and a body of the iodizer;
e. opening a vacuum valve to connect to the vacuum unit, and vacuumizing to less than 6.0×10⁻²Pa, wherein closing the vacuum valve when a tested pressure rise rate is less than 2.0Pa/h;
f. adding iodine into the iodine box;
g. vacuumizing the iodine box to less than 6.0×10⁻¹Pa, simultaneously closing a ball valve;
h. sealing the iodine box, and closing the vacuum valve;
i. hoisting the iodizer integrally into a thermostatic device, wherein the thermostatic device has been heated to 240-300°C;
j. connecting the power supply unit to heat the core wire, wherein a current is set within 30-60A and a voltage is set within 80-120V, and a corresponding temperature of the core wire is 1400-1600°C;
k. opening the ball valve, adding iodine into the iodizer, the iodine reacting with the rough hafnium rapidly to produce hafnium tetrafluoride (Hfl₄), evaporating the hafnium tetrafluoride, decomposing the hafnium tetrafluoride into hafnium and the iodine when the hafnium tetrafluoride touches the core wire of 1400-1600°C, crystallizing the hafnium on the core wire, and the iodine continuing to react with the rough hafnium, wherein reactions are repeated;
l. decreasing the voltage continuously with an increase of the current to maintain the temperature of the core wire at 1400-1600°C, and shutting off the power supply unit when the current reaches 1000-3000A;
m. hoisting the iodizer out of the thermostatic device to a preset position for air cooling;
n. adding water into the iodizer after cooling for 24 hours; and
o. finally opening the cover of the iodizer to take out the hafnium crystal bar.

A cooling unit is started when a temperature of a saline solution exceeds 300°C, so that a temperature of the rough hafnium is maintained at 240-300°C.

The present invention has the following advantages as compared with the prior art:
The present invention can increase the production speed of the hafnium crystal bar and the production speed is uniform. The duration of production is long and the production of a single furnace is improved. The energy consumption is reduced. The use of accessories and supplies are also reduced. The contents of iron, nickel and chromium are greatly reduced. Thus, the product quality is improved.

### Brief Description of the Drawings

The present invention will now be described in further detail with reference to the accompanying drawings:
Figure 1 is a structural schematic view of a production system of a hafnium crystal bar provided in the present invention;
Figure 2 is a structural schematic view of mounted molybdenum sleeve and molybdenum electrode rod provided in the present invention;
Figure 3 is a structural schematic view of mounted anti-discharge ceramic piece provided in the present invention;
Figure 4 is a structural schematic view of a core wire fixing device provided in the present invention;
Figure 5 is top view of Figure 4;
Figure 6 is a structural schematic view of a sealed iodizer provided in the present invention.

### Reference signs:

1 power supply unit, 2 iodizer, 3 molybdenum insulator, 4 thermostatic device, 5 iodine box, 6 ball valve, 7 rough hafnium, 8 electrode rod, 9 molybdenum electrode rod, 10 electrode tip, 11 core wire, 12 molybdenum sleeve, 13 insulating ferrule, 14 anti-discharge ceramic piece, 15 molybdenum rod, 16 molybdenum plate, 17 insulating ceramic piece, 18 thermally conductive fuel tank, 19 cooling coil, 20 condenser, 21 vacuum valve, 22 flange, 23 cover of the iodizer, 24 sealing ring, 25 secondary sealing device, 26 circulating pipe, 27 agitating shaft, 28 motor, 29 thermocouple, 30 electric heating wire.

### Detailed Description of the Invention

To better understand the purpose, technical solutions and the advantages of the present invention, the technical solutions in the embodiments are clearly and fully described with reference to the accompanying drawings of the present invention. It is obvious that the embodiments are only certain embodiments of the present invention, but not all the embodiments of the present invention. The scope of the present invention is defined by the appended claims.

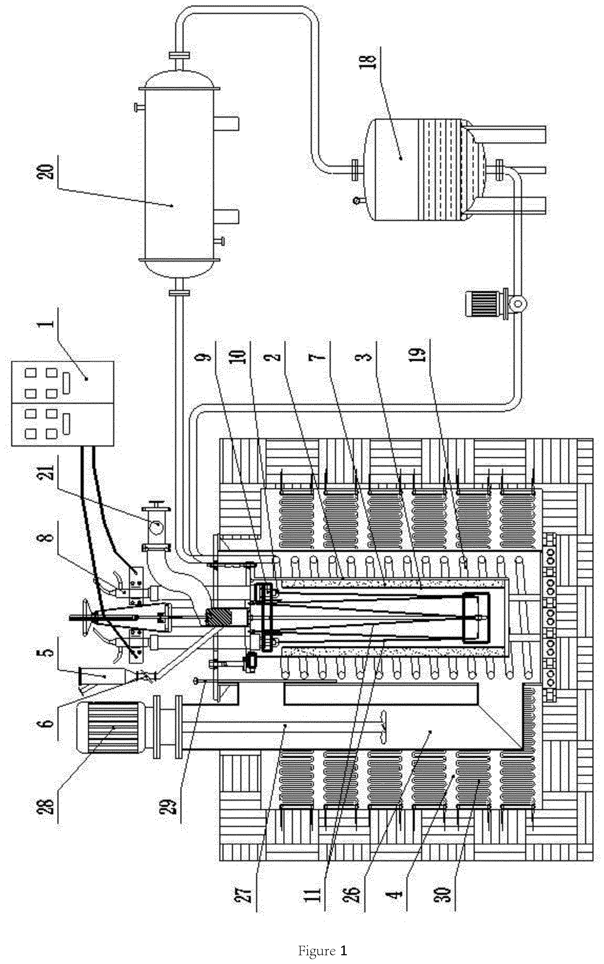

As shown in Fig. 1 to Fig. 6, the present invention provides a production system for a hafnium crystal bar, including a power supply unit 1 with a large DC current, an iodizer 2, a molybdenum insulator 3 provided inside the iodizer 2, a thermostatic device 4 capable of accommodating the iodizer 2, a cooling unit for cooling the iodizer 2, a vacuum unit for vacuumizing the iodizer 2, an iodine box 5 controlled by a ball valve 6 and used for adding iodine into the iodizer 2 , an electrode unit electrically connected to the power supply unit 1 and disposed above the iodizer 2, a crystallization unit provided inside the iodizer 2 and connected to the electrode unit, and rough hafnium 7 provided between the iodizer 2 and the molybdenum insulator 3, wherein the molybdenum insulator 3 is made of a molybdenum material.

A voltage of the power supply unit 1 is steplessly adjustable within the range of 1.0V-180V, with a preset maximum output current of 3000A.

The thermostatic device 4 is a structure with an insulation layer provided outside an inner tank, and an electric heating wire 30 is provided between the inner tank and the insulation layer. The electric heating wire is a 30KW electric heating wire, and the inner tank is made of 316L stainless steel, with an inner diameter of 800-1200 mm and a net height of 1300-2200 mm. The inner tank of the thermostatic device 4 is filled with a saline solution. The iodizer 2 is fixedly mounted inside the inner tank of the thermostatic device 4 and is completely immersed in the saline solution. The saline solution is a nitrate. The thermostatic device 4 is further provided with a thermocouple 29 extending into the saline solution, wherein the thermocouple is used for measuring the temperature of the saline solution.

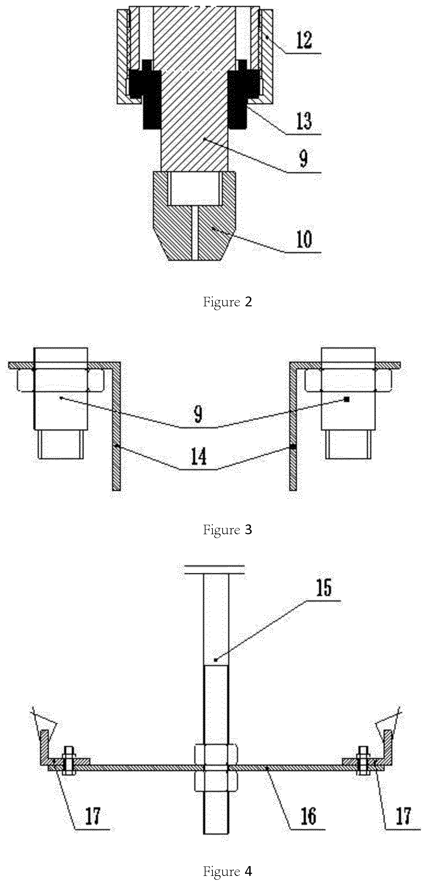

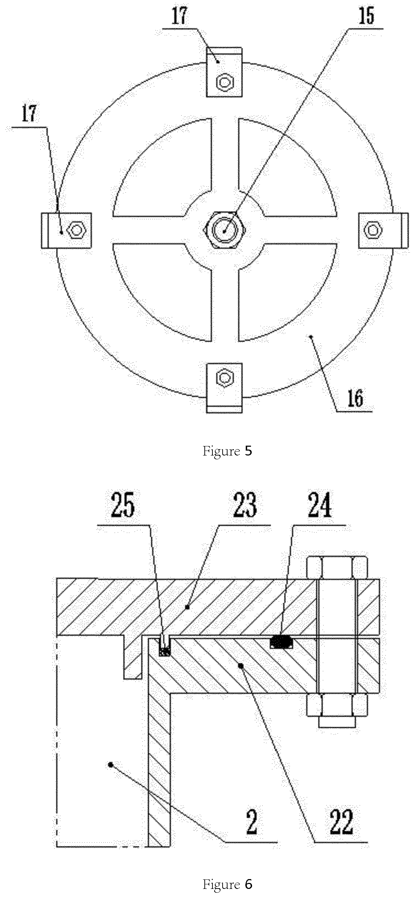

The iodizer 2 is made of 316L stainless steel, with an inner diameter of 300-600 mm and a net height of 900-1800 mm. The iodizer can be integrally put into the thermostatic device 4. A core wire fixing device is provided inside the iodizer 2. As shown in Fig. 4 and Fig. 5, the core fixing device includes a molybdenum rod 15 connected to the cover 23 of the iodizer, a molybdenum plate 16 connected to the molybdenum rod 15, and an insulating ceramic piece 17 connected to the molybdenum plate 16. The insulating ceramic piece 17 an insulated electric ceramic piece. A molybdenum wire for fixing the core wire 11 is fastened to the insulated electric ceramic piece to prevent the core wire 11 from distortion because of the hoisting vibration and heating, so as to avoid the contact between the core wire 11 and the molybdenum insulator 3 which results in a short circuit, etc. Meanwhile, it makes it possible to arrange longer core wire 11 within a limited space, therefore, the production of a single furnace is improved. There is a larger gap in the middle of the molybdenum plate 16 shown in Fig. 5 to minimize the effect on the growth of the hafnium crystal bar.

The electrode unit includes an electrode rod 8 made of a chromium-zirconium-copper rod, a molybdenum electrode rod 9 located below the electrode rod 8 which is connected to the molybdenum electrode rod 9 by a screw thread, an electrode tip 10 located at the bottom of the molybdenum electrode rod 8. The core wire 11 of the crystallization unit is a hafnium wire with a diameter of 1.0-4.0 mm and a length of 2-7 m. Both ends of the core wire 11 are connected to the electrode tip 10 and fixed to the core wire fixing device. The electrode rod 8 is provided with a water inlet and a water outlet respectively connected to the cooling unit.

A bottom of the molybdenum electrode rod 9 is fixedly connected to a cover 23 of the iodizer through a molybdenum sleeve 12, and an insulating ferrule 13 is arranged between the molybdenum electrode rod 9 and the molybdenum sleeve 12. As shown in Fig. 2, on the one hand, the molybdenum sleeve 12 can be used for fixing the electrode tip 10; on the other hand, the molybdenum sleeve 12 can effectively avoid the pollution to the hafnium crystal bar caused by the iron, nickel, chromium etc.

A lower portion of the molybdenum electrode rod 9 is fixedly provided with an anti-discharge ceramic piece 14 with an inverted L-shaped cross section, as shown in Fig. 3.

The cooling unit includes a thermally conductive fuel tank 18, a cooling coil 19 peripherally provided around an outer wall of the iodizer 2, and a condenser 20. The thermally conductive fuel tank 18 provides cooling oil to the cooling coil 19 via an oil pump, then the cooling oil comes out from an outlet of the cooling coil 19 and goes into the condenser 20 to cool down, and thus a circulating cooling loop is formed. The thermostatic device 4 is further provided with a circulating and stirring system, and the circulating and stirring system includes a circulating pipe 26 provided on a side of the inner tank of the thermostatic device 4. An agitating shaft 27 is provided inside the circulating pipe 26, and an agitating vane is provided at a lower part of the agitating shaft 27. An upper part of the agitating shaft 27 extends outside of the circulating pipe 26 and connects to an output shaft of a motor 28. The motor 28 can be a 2.2KW motor of frequency control equipment.

The vacuum unit is connected to the iodizer 2 through a vacuum valve 21. The vacuum unit includes a triplex pump, wherein a primary pump is a 2×75 mechanical pump, a secondary pump is a 150 lobe pump, and a tertiary pump is a KT200 diffusion pump.

As shown in Fig. 6, the cover 23 of the iodizer 2 is fixedly connected to a flange 22 of the iodizer body. A sealing ring 24 and a secondary sealing device 25 are arranged between the cover 23 of the iodizer and the flange 22 to avoid the ineffective deposition of the iodine.

Simultaneously, according to the above production system, the present invention also provides a method for producing a hafnium crystal bar using the production system of appended claim 1, the method including the following steps:
a. drying the rough hafnium 7;
b. putting the rough hafnium 7 into a gap between an inner wall of the iodizer 2 and the molybdenum insulator 3;
c. hanging the core wire 11 onto the electrode tip 10 and fixing the core wire 11 to the core wire fixing device;
d. hermetically connecting the cover 23 of the iodizer and the body of the iodizer 2;
e. opening the vacuum valve 21 to connect to the vacuum unit, and vacuumizing to less than 6.0×10⁻²Pa, and closing the vacuum valve 21 when a tested pressure rise rate is less than 2.0 Pa/h;
f. adding iodine into the iodine box 5;
g. vacuumizing the iodine box 5 to less than 6.0×10⁻¹Pa, and closing the ball valve 21;
h. sealing the iodine box 5, and closing the vacuum valve 21;
i. hoisting the iodizer 2 integrally into the thermostatic device 4, wherein the thermostatic device 4 has been heated to 240-300°C;
j. connecting the power supply unit to heat the core wire 11, wherein a current is set within 30-60A, and a voltage is set within 80-120V, and a corresponding temperature of the core wire is 1400-1600°C;
k. opening the ball valve 6 and adding iodine into the iodizer 2, wherein the iodine reacts with the rough hafnium 7 rapidly to produce a hafnium tetrafluoride (Hfl₄) which evaporates, and the hafnium tetrafluoride decomposes into hafnium and iodine when touching the core wire 11 of 1400-1600°C, the hafnium crystallizes on the core wire 11 and the iodine continues to react with the rough hafnium 7, and the reactions are repeated;
l. decreasing the voltage continuously with an increase in the current to maintain the temperature of the core wire 11 at 1400-1600°C, wherein the power supply unit is shut off when the current reaches 1000-3000A;
m. hoisting the iodizer 2 out of the thermostatic device to a certain position for air cooling;
n. adding water into the iodizer 2 after cooling for 24 hours; and
o. finally opening the cover 23 of the iodizer to take the hafnium crystal bar out.

During the production process, the cooling unit is started if the temperature of the saline solution exceeds 300, so that the temperature of the rough hafnium 7 is maintained at 240-300°C.

The whole production process lasts for 70-95 hours with a growth rate of 132 g/ m.h, and the efficiency doubles compared with a growth rate of 58 g/m.h of the foreign companies while the production of the single furnace reaches 50-100kg. Furthermore, the invention adds a screw rod 46 for controlling the upward and downward movements, and a piston 8 connected to the screw rod 46. After adding iodine, the piston 8 is sunk to be parallel to the bottom of the cover of the iodizer, so as to prevent the iodine vapor from escaping into the vacuum pipe 11, and thus maximize the participation of iodine in the reaction and prolong the reaction time.

To optimize the production process conditions, after years of continuous research and technical development, the applicant has performed nearly thousands of trials and obtained the following process parameters: a temperature of the rough hafnium is 240-300°C, a temperature of the core wire is 1400-1600°C and an initial vacuum degree is below 6.0×10⁻²Pa.

Finally, it should be noted that above embodiments are merely intended to illustrate the technical solutions of the present invention, but not intended to limit the scope of the present invention. While the present invention has been described in detail with reference to the above embodiments, one skilled in the art should understand that it is still possible to modify the technical solutions described in the above embodiments. The scope of the invention is defined by the appended claims.

## Claims

1. A production system for a hafnium crystal bar comprising:
a power supply unit with a large DC current (1);
an iodizer(2);
a molybdenum insulator (3) provided inside the iodizer(2);
a thermostatic device (4) capable of accommodating the iodizer(2);
a cooling unit for cooling the iodizer(2);
a vacuum unit for vacuumizing the iodizer(2);
an iodine box (5) for adding iodine into the iodizer(2), wherein the iodine box is controlled by a ball valve(6);
an electrode unit (8-10) electrically connected to the power supply unit, wherein the electrode unit (8-10) is disposed above the iodizer(2); and
a crystallization unit provided inside the iodizer(2), wherein the crystallization unit is connected to the electrode unit;
wherein, the thermostatic device(4) is a structure with an insulation layer provided outside an inner tank, wherein the inner tank of the thermostatic device(4) is filled with a saline solution;
wherein the iodizer(2) is fixedly mounted inside the inner tank of the thermostatic device(4) and is completely immersed in the saline solution;
wherein the thermostatic device(4) is further provided with a thermocouple(29) extending into the saline solution, wherein the thermocouple(29) is used for measuring a temperature of the saline solution;
the electrode unit comprises an electrode rod (8), a molybdenum electrode rod (9) located below the electrode rod (8), an electrode tip (10) located at a bottom of the molybdenum electrode rod (9), wherein the molybdenum electrode rod (9) is connected to the electrode rod(8) by a screw thread, wherein a core wire (11) of the crystallization unit is a hafnium wire and both ends of the core wire are connected to the electrode tip (10);
wherein a core wire fixing device is provided inside the iodizer (2), wherein the core wire fixing device comprises a molybdenum rod (15) connected to the cover of the iodizer (23), a molybdenum plate (16) connected to the molybdenum rod (15), and an insulating ceramic piece (17) connected to the molybdenum plate (16), wherein a molybdenum wire for fixing the core wire (11) is fastened to the insulating ceramic piece (17);
**characterized in that** the electrode rod (8) is made of a chromium-zirconium-copper rod;
the molybdenum plate (16) is provided with a gap in the middle of the molybdenum plate (16) to minimize the effect on the growth of the hafnium crystal bar; an electric heating wire (30) is provided between the inner tank and the insulation layer;
wherein a bottom of the molybdenum electrode rod (9) is fixedly connected to a cover of the iodizer (23) through a molybdenum sleeve (12), and an insulating ferrule (13) is arranged between the molybdenum electrode rod (9) and the molybdenum sleeve (12).

2. The production system for a hafnium crystal bar according to claim 1, **characterized in that** a lower portion of the molybdenum electrode rod(9) is fixedly provided with an anti-discharge ceramic piece(14) having an inverted L-shaped cross section.

3. The production system for a hafnium crystal bar according to claim 1, **characterized in that** the cooling unit comprises a thermally conductive fuel tank(18), a cooling coil(19) peripherally provided around an outer wall of the iodizer(2), a condenser(20), and a circulating and stirring system in the thermostatic device(4); wherein the circulating and stirring system comprises a circulating pipe(26) provided on a side of the inner tank of the thermostatic device(4), wherein an agitating shaft(27) is provided in the circulating pipe(26); wherein an agitating vane is provided at a lower part of the agitating shaft(27), and an upper part of the agitating shaft(27) extends outside of the circulating pipe(26) and connects to a output shaft of a motor(28).

4. The production system for a hafnium crystal bar according to claim 1, **characterized in that** a cover of the iodizer(23) is fixedly connected to a flange(22) of a body of the iodizer(2), wherein a sealing ring(24) and a secondary sealing device(25) are arranged between the cover of the iodizer(23) and the flange(22).

5. The production system for a hafnium crystal bar according to claim 1, **characterized in that** the vacuum unit is connected to the iodizer(2) through a vacuum valve(21), wherein the vacuum unit includes a triplex pump, wherein a primary pump is a mechanical pump, a secondary pump is a lobe pump and a tertiary pump is a diffusion pump.

6. A method for producing a hafnium crystal bar using the production system of claim 1, comprising the following steps:
a. drying rough hafnium(7);
b. adding the rough hafnium(7) into a gap between an inner wall of an iodizer(2) and a molybdenum insulator(3);
c. hanging a core wire(11) onto an electrode tip(10) and fixing the core wire(11) into a core wire fixing device;
d. hermetically connecting a cover of the iodizer(23) and a body of the iodizer(2);
e. opening a vacuum valve(21) to connect to the vacuum unit, and vacuumizing to less than 6.0×10⁻²Pa, wherein closing the vacuum valve(21) when a tested pressure rise rate is less than 2.0Pa/h;
f. adding iodine into the iodine box(5);
g. vacuumizing the iodine box(5) to less than 6.0×10⁻¹Pa, simultaneously closing a ball valve(6);
h. sealing the iodine box(5), and closing the vacuum valve(21);
i. hoisting the iodizer(2) integrally into a thermostatic device(4), wherein the thermostatic device(4) has been heated to 240-300°C;
j. connecting the power supply unit to heat the core wire(11), wherein a current is set within 30-60A and a voltage is set within 80-120V, and a corresponding temperature of the core wire is 1400-1600°C;
k. opening the ball valve(6), adding iodine into the iodizer(2), the iodine reacting with the rough hafnium(7) rapidly to produce hafnium tetrafluoride (Hfl4), evaporating the hafnium tetrafluoride, decomposing the hafnium tetrafluoride into hafnium and the iodine when the hafnium tetrafluoride touches the core wire(11) of 1400-1600°C, crystallizing the hafnium on the core wire(11), and the iodine continuing to react with the rough hafnium(7), wherein reactions are repeated;
l. decreasing the voltage continuously with an increase of the current to maintain the temperature of the core wire(11) at 1400-1600°C, and shutting off the power supply unit when the current reaches 1000-3000A;
m. hoisting the iodizer(2) out of the thermostatic device to a preset position for air cooling;
n. adding water into the iodizer(2) after cooling for 24 hours; and
o. finally opening the cover of the iodizer(23) to take out the hafnium crystal bar.

7. The method for producing the hafnium crystal bar according to claim 6, **characterized in that** a cooling unit is started when a temperature of a saline solution exceeds 300°C, so that a temperature of the rough hafnium(7) is maintained at 240-300°C.

## Patentansprüche

1. Produktionssystem für einen Hafniumkristallstab, umfassend:
eine Stromversorgungseinheit mit einem großen Gleichstrom (1);
ein Jodierer (2);
einen Molybdänisolator (3), der in dem Jodierer (2) vorgesehen ist;
eine Thermostatvorrichtung (4), die den Jodierer (2) aufnehmen kann; eine Kühleinheit für Abkühlen des Jodierers (2);
eine Vakuumeinheit zum Staubsaugen des Jodierers (2);
eine Jodbox (5) zum Hinzufügen von Jod in den Jodierer (2), wobei die Jodbox durch einen Kugelhahn (6) gesteuert wird;
eine Elektrodeneinheit (8-10), die elektrisch mit der Stromversorgungseinheit verbunden ist, wobei die Elektrodeneinheit (8-10) über dem Jodierer (2) angeordnet ist; und
eine Kristallisationseinheit, die innerhalb des Jodierers (2) vorgesehen ist, wobei die Kristallisationseinheit mit der Elektrodeneinheit verbunden ist;
wobei die Thermostatvorrichtung (4) eine Struktur mit einer Isolationsschicht ist, die außerhalb eines Innentanks vorgesehen ist, wobei der Innentank der Thermostatvorrichtung (4) mit einer Salzlösung gefüllt ist;
wobei der Jodierer (2) fest im Innentank der Thermostatvorrichtung (4) montiert ist und vollständig in die Salzlösung eingetaucht ist;
wobei die Thermostatvorrichtung (4) ferner mit einem Thermoelement (29) versehen ist, das sich in die Salzlösung erstreckt, wobei das Thermoelement (29) zum Messen einer Temperatur der Salzlösung verwendet wird;
die Elektrodeneinheit umfasst einen Elektrodenstab (8), einen Molybdänelektrodenstab (9), der sich unter dem Elektrodenstab (8) befindet, eine Elektrodenspitze (10), die sich an einem Boden des Molybdänelektrodenstabs (9) befindet, wobei die Molybdänelektrodenstab (9) ist mit dem Elektrodenstab (8) durch ein Schraubengewinde verbunden, wobei ein Kerndraht (11) der Kristallisationseinheit ein Hafniumdraht ist und beide Enden des Kerndrahtes mit der Elektrodenspitze (10) verbunden sind;
wobei eine Kerndraht-Befestigungsvorrichtung innerhalb des Jodierers (2) vorgesehen ist, wobei die Kerndraht-Befestigungsvorrichtung einen Molybdänstab (15) umfasst, der mit der Abdeckung des Jodierers (23) verbunden ist, eine Molybdänplatte (16), die mit dem Molybdänstab (15) verbunden ist und ein isolierendes Keramikstück (17), das mit der Molybdänplatte (16) verbunden ist, wobei ein Molybdändraht zum Befestigen des Kerndrahtes (11) an dem isolierenden Keramikstück (17) befestigt ist;
**dadurch gekennzeichnet, dass** der Elektrodenstab (8) aus einem Chrom-Zirkonium-Kupfer Stab besteht;
die Molybdänplatte (16) ist mit einem Spalt in der Mitte der Molybdänplatte (16) versehen, um die Auswirkung auf das Wachstum des Hafniumkristallstabs zu minimieren;
zwischen dem Innentank und der Isolationsschicht ist ein elektrischer Heizdraht (30) vorgesehen;
wobei ein Boden des Molybdänelektrodenstabs (9) durch eine Molybdänhülse (12) fest mit einer Abdeckung des Jodierers (23) verbunden ist und eine isolierende Zwinge (13) zwischen dem Molybdänelektrodenstab (9) und dem Molybdänhülse (12) angeordnet ist.

2. Herstellungssystem für einen Hafniumkristallstab nach Anspruch 1, **dadurch gekennzeichnet, dass** ein unterer Teil des Molybdänelektrodenstabes (9) fest mit einem Anti-Entladungs-Keramikstück (14) mit einem umgekehrten L-förmigen Querschnitt versehen ist.

3. Produktionssystem für einen Hafniumkristallstab nach Anspruch 1, **dadurch gekennzeichnet, dass** die Kühleinheit einen wärmeleitenden Kraftstofftank (18), eine Kühlschlange (19), die peripher um eine Außenwand des Jodierers (2) vorgesehen ist, einen Kondensator umfasst (20) und ein Umwälz- und Rührsystem in der Thermostatvorrichtung (4); wobei das Zirkulations- und Rührsystem ein Zirkulationsrohr (26) umfasst, das an einer Seite des Innentanks der Thermostatvorrichtung (4) vorgesehen ist, wobei eine Rührwelle (27) in dem Zirkulationsrohr (26) vorgesehen ist; wobei eine Rührschaufel an einem unteren Teil der Rührwelle (27) vorgesehen ist und ein oberer Teil der Rührwelle (27) sich außerhalb des Umlaufrohrs (26) erstreckt und mit einer Ausgangswelle eines Motors (28) verbunden ist.

4. Herstellungssystem für einen Hafniumkristallstab nach Anspruch 1, **dadurch gekennzeichnet, dass** eine Abdeckung des Jodierers (23) fest mit einem Flansch (22) eines Körpers des Jodierers (2) verbunden ist, wobei ein Dichtring (24) und eine sekundäre Dichtungsvorrichtung (25) sind zwischen der Abdeckung des Jodierers (23) und dem Flansch (22) angeordnet.

5. Produktionssystem für einen Hafniumkristallstab nach Anspruch 1, **dadurch gekennzeichnet, dass** die Vakuumeinheit über ein Vakuumventil (21) mit dem Jodierer (2) verbunden ist, wobei die Vakuumeinheit eine Triplexpumpe umfasst, wobei eine Primärpumpe ist eine mechanische Pumpe, eine Sekundärpumpe ist eine Nockenpumpe und eine Tertiärpumpe ist eine Diffusionspumpe.

6. Verfahren zur Herstellung eines Hafniumkristallstabs unter Verwendung des Produktionssystems nach Anspruch 1, umfassend die folgenden Schritte:
a. Trocknen von rauem Hafnium (7);
b. Hinzufügen des rauen Hafniums (7) in einen Spalt zwischen einer Innenwand eines Jodierers (2) und einem Molybdänisolator (3);
c. Aufhängen eines Kerndrahtes (11) an eine Elektrodenspitze (10) und Befestigen des Kerndrahtes (11) in einer Kerndraht-Befestigungsvorrichtung;
d. hermetische Verbindung einer Abdeckung des Jodierers (23) und eines Körpers des Jodierers (2);
e. Öffnen eines Vakuumventils (21) zum Anschließen an die Vakuumeinheit und Staubsaugen auf weniger als 6.0×10⁻²Pa, wobei das Vakuumventil (21) geschlossen wird, wenn eine getestete Druckanstiegsrate weniger als 2.0Pa/h beträgt;
f. Hinzufügen von Jod in die Jodbox (5);
g. Staubsaugen der Jodbox (5) auf weniger als 6.0x10⁻¹Pa, Schließung gleichzeitig ein Kugelhahn (6);
h. Verschließen der Jodbox (5) und Schließen des Vakuumventils (21);
i. Heben des Jodierers (2) einstückig in eine Thermostatvorrichtung (4), wobei die Thermostatvorrichtung (4) auf 240-300°C erhitzt worden ist;
j. Anschließen des Netzteils zum Erhitzen des Kerndrahtes (11), wobei ein Strom innerhalb von 30-60A und eine Spannung innerhalb von 80-120V eingestellt wird und eine entsprechende Temperatur des Kerndrahtes 1400-1600°C beträgt;
k. Öffnen des Kugelhahns (6), Zugabe von Jod in den Jodierer (2), Reagieren von Jod schnell mit dem rauen Hafnium (7), um Hafniumtetrafuorid (Hfl₄) zu erzeugen, Verdampfung von Hafniumtetrafuorid, Zersetzung von Hafniumtetrafuorid in Hafnium und von Jod wenn das Hafniumtetrafuorid den Kerndraht (11) von 1400-1600°C berührt, Kristallisation von Hafnium auf dem Kerndraht (11) und Fortsetzung von Iod mit dem rauen Hafnium (7) zu reagieren, wobei die Reaktionen wiederholt werden;
l. Verringern der Spannung kontinuierlich mit zunehmendem Strom, um die Temperatur des Kerndrahtes (11) bei 1400-1600°C zu halten, und Abschalten des Netzteils, wenn der Strom 1000-3000A erreicht;
m. Heben des Jodierers (2) aus der Thermostatvorrichtung in eine voreingestellte Position zur Luftkühlung;
n. Hinzufügen von Wasser in den Jodierer (2) nach 24-stündigem Abkühlen; und
o. Öffnen der Abdeckung des Jodierers (23) schließlich, um den Hafniumkristallstab herauszunehmen.

7. Verfahren zur Herstellung des Hafniumkristallstabes nach Anspruch 6, **dadurch gekennzeichnet, dass** eine Kühleinheit gestartet wird, wenn eine Temperatur einer Salzlösung 300°C überschreitet, so dass eine Temperatur des rauen Hafniums (7) bei 240-300°C gehalten wird.

## Revendications

1. Système de production pour une barre de cristal d'hafnium comprenant :
une unité d'alimentation électrique avec un courant continu important (1) ;
un iodiseur (2) ;
un isolateur de molybdène (3) prévu à l'intérieur de l'iodiseur (2) ;
un dispositif thermostatique (4) capable d'accueillir l'iodiseur (2) ; une unité de refroidissement pour le refroidissement de l'iodiseur (2) ;
une unité à vide pour la mise sous vide de l'iodiseur (2) ;
une boîte à iode (5) pour l'ajout d'iode dans l'iodiseur (2), dans laquelle la boîte à iode est contrôlée par une vanne à bille (6) ;
une unité d'électrode (8-10) connectée électriquement à l'unité d'alimentation électrique, dans laquelle l'unité d'électrode (8-10) est disposée au-dessus de l'iodiseur (2); et
une unité de cristallisation prévue à l'intérieur de l'iodiseur (2), dans laquelle l'unité de cristallisation est connectée à l'unité d'électrode ;
dans lequel, le dispositif thermostatique (4) est une structure avec une couche isolante prévue à l'extérieur d'un réservoir intérieur, dans lequel le réservoir intérieur du dispositif thermostatique (4) est rempli d'une solution saline ;
dans lequel l'iodiseur (2) est monté de manière fixe à l'intérieur du réservoir intérieur du dispositif thermostatique (4) et est complètement immergé dans la solution saline ;
dans lequel le dispositif thermostatique (4) est en outre pourvu d'un thermocouple (29) s'étendant dans la solution saline, dans lequel le thermocouple (29) est utilisé pour mesurer une température de la solution saline ;
l'unité d'électrode comprend une tige d'électrode (8), une tige d'électrode de molybdène (9) située sous la tige d'électrode (8), une pointe d'électrode (10) située au bas de la tige d'électrode de molybdène (9), dans laquelle la tige d'électrode de molybdène (9) est connectée à la tige d'électrode (8) par un filetage, dans lequel un fil central (11) de l'unité de cristallisation est un fil d'hafnium et les deux extrémités du fil central sont connectées à la pointe d'électrode (10) ;
dans lequel un dispositif de fixation du fil central est prévu à l'intérieur de l'iodiseur (2), dans lequel le dispositif de fixation du fil central comprend une tige de molybdène (15) connectée au couvercle de l'iodiseur (23), une plaque de molybdène (16) connectée à la tige de molybdène (15), et une pièce isolante de céramique (17) connectée à la plaque de molybdène (16), dans laquelle un fil de molybdène pour la fixation du fil central (11) est attaché à la pièce isolante de céramique (17) ;
**caractérisé en ce que** la tige d'électrode (8) est constituée d'une tige de chrome-zirconium-cuivre ;
la plaque de molybdène (16) est pourvue d'un espace au milieu de la plaque de molybdène (16) pour minimiser l'effet sur la croissance de la barre de cristal d'hafnium ;
un fil chauffant électrique (30) est prévu entre le réservoir intérieur et la couche isolante ;
dans lequel un fond de la tige d'électrode de molybdène (9) est connecté de manière fixe à un couvercle de l'iodiseur (23) par un manchon de molybdène (12), et une virole isolante (13) est agencée entre la tige d'électrode de molybdène (9) et le manchon de molybdène (12).

2. Système de production pour une barre de cristal d'hafnium selon la revendication 1, **caractérisé en ce qu'**une partie inférieure de la tige d'électrode de molybdène (9) est pourvue de façon fixe d'une pièce céramique anti-décharge (14) ayant une section transversale en forme de L inversé.

3. Système de production pour une barre de cristal d'hafnium selon la revendication 1, **caractérisé en ce que** l'unité de refroidissement comprend un réservoir de carburant thermoconducteur (18), un serpentin de refroidissement (19) prévu périphériquement autour d'une paroi extérieure de l'iodiseur (2), un condenseur (20), et un système de circulation et d'agitation dans le dispositif thermostatique (4) ; dans lequel le système de circulation et d'agitation comprend un tuyau de circulation (26) prévu sur un côté de du réservoir intérieur du dispositif thermostatique (4), dans lequel un arbre d'agitation (27) est prévu dans le tuyau de circulation (26) ; dans lequel une pale d'agitation est prévue à une partie inférieure de l'arbre d'agitation (27), et une partie supérieure de l'arbre d'agitation (27) s'étend à l'extérieur du tuyau de circulation (26) et se connecte à un arbre de sortie d'un moteur (28).

4. Système de production pour une barre de cristal d'hafnium selon la revendication 1, **caractérisé en ce qu'**un couvercle de l'iodiseur (23) est connecté de manière fixe à une bride (22) d'un corps de l'iodiseur (2), dans lequel une bague d'étanchéité (24) et un dispositif d'étanchéité secondaire (25) sont agencés entre le couvercle de l'iodiseur (23) et la bride (22).

5. Système de production pour une barre de cristal d'hafnium selon la revendication 1, **caractérisé en ce que** l'unité à vide est connectée à l'iodiseur (2) par une vanne à vide (21), dans lequel l'unité à vide comprend une pompe triplex, dans lequel une pompe primaire est une pompe mécanique, une pompe secondaire est une pompe à lobes et une pompe tertiaire est une pompe à diffusion.

6. Procédé de production d'une barre de cristal d'hafnium utilisant le système de production selon la revendication 1, comprenant les étapes suivantes :
a. le séchage du hafnium brut (7) ;
b. l'ajout d'hafnium brut (7) dans un espace entre une paroi intérieure d'un iodiseur (2) et un isolateur de molybdène (3) ;
c. l'accrochage d'un fil central (11) sur une pointe d'électrode (10) et la fixation du fil central (11) dans un dispositif de fixation du fil central ;
d. la connexion hermétique d'un couvercle de l'iodiseur (23) et d'un corps de l'iodiseur (2) ;
e. l'ouverture d'une vanne à vide (21) pour la connexion à l'unité à vide, et la mise sous vide à moins de 6.0x10⁻²Pa, dans laquelle la fermeture de la vanne à vide (21) lorsqu'un taux de montée en pression testé est inférieur à 2.0Pa/h ;
f. l'ajout d'iode dans la boîte à iode (5) ;
g. la mise sous vide de la boîte à iode (5) à moins de 6.0x10⁻¹Pa, en fermant simultanément une vanne à bille (6) ;
h. le scellement de la boîte à iode (5), et la fermeture de la vanne à vide (21) ;
i. le hissage de l'iodiseur (2) intégralement dans un dispositif thermostatique (4), dans lequel le dispositif thermostatique (4) a été chauffé à 240-3 00°C ;
j. la connexion de l'unité d'alimentation électrique pour chauffer le fil chauffant (11), dans laquelle un courant est réglé dans 30-60A et une tension est réglée dans 80-120V, et une température correspondante du fil central est de 1400-1600°C ;
k. l'ouverture de la vanne à bille (6), l'ajout d'iode dans l'iodiseur (2), l'iode réagissant rapidement avec l'hafnium brut (7) pour produire du tétrafluorure d'hafnium (Hfl₄), l'évaporation du tétrafluorure d'hafnium, la décomposition du tétrafluorure d'hafnium en hafnium et en iode lorsque le tétrafluorure d'hafnium touche le fil central (11) de 1400-1600°C, la cristallisation du hafnium sur le fil central (11), et l'iode continuant à réagir avec l'hafnium brut (7), dans lequel les réactions sont répétées ;
l. la diminution continue de la tension avec une augmentation du courant pour maintenir la température du fil central (11) à 1400-1600°C, et la fermeture de l'unité d'alimentation électrique lorsque le courant atteint 1000-3000A ;
m. le hissage de l'iodiseur (2) hors du dispositif thermostatique à une position prédéfinie pour le refroidissement par air ;
n. l'ajout d'eau dans l'iodiseur (2) après refroidissement pendant 24 heures; et
o. enfin l'ouverture du couvercle de l'iodiseur (23) pour sortir la barre de cristal d'hafnium.

7. Procédé de production d'une barre de cristal d'hafnium selon la revendication 6, **caractérisé en ce qu'**une unité de refroidissement est mise en marche lorsqu'une température d'une solution saline dépasse 300°C, de sorte qu'une température du hafnium brut (7) est maintenue à 240-300°C.
